(19) **Europäisches Patentamt / European Patent Office / Office européen des brevets**

(11) **EP 1 795 293 A1**

(12) **EUROPEAN PATENT APPLICATION**
published in accordance with Art. 158(3) EPC

(43) Date of publication:
**13.06.2007 Bulletin 2007/24**

(21) Application number: **05768900.2**

(22) Date of filing: **08.08.2005**

(51) Int Cl.:
**B23K 35/22** (2006.01)     **B23K 35/26** (2006.01)
**C22C 13/00** (2006.01)

(86) International application number:
**PCT/JP2005/014508**

(87) International publication number:
**WO 2006/038376** (13.04.2006 Gazette 2006/15)

(84) Designated Contracting States:
**DE FR GB**

(30) Priority: **30.09.2004 JP 2004285779**

(71) Applicant: **Tamura Corporation**
**Tokyo 178-8511 (JP)**

(72) Inventors:
• **FURUNO, Masahiko, TAMURA CORPORATION**
**Tokyo 1788511 (JP)**
• **SAITO, Hiroshi, TAMURA CORPORATION**
**Tokyo 1788511 (JP)**
• **SAKAMOTO, Isao, TAMURA CORPORATION**
**Tokyo 1788511 (JP)**
• **SHIRAI, Masaru, TAMURA CORPORATION**
**Tokyo 1788511 (JP)**

(74) Representative: **Whalley, Kevin**
**Marks & Clerk**
**90 Long Acre**
**London WC2E 9RA (GB)**

(54) **SOLDER COMPOSITION AND SOLDER LAYER FORMING METHOD USING THE SAME**

(57)     [Problem to be Solved] [Solution] A solder composition 10 is for forming a solder layer on an electrode 21 provided on a substrate 20. The solder composition 10 includes solder powder composed of a plurality of solder particles 12 coated with organic films 11, and a medium 13 having a boiling point not lower than the melting point of the solder powder. The solder layer on the electrode 21 grows by coalescence of the solder particles 12 with the solder layer. Therefore, when the coalescence of the solder particles proceeds and the amount of the organic film per unit surface area of the solder layer reaches a certain level, the growth of the solder layer stops. Namely, the final solder amount of the solder layer is determined depending on the initial size of the solder particle 12 and amount of the organic film 11. Thereby, it is possible to inhibit coalescence of the solder particles 12 on the electrode 21 beyond necessity, so a short-circuit failure of the electrode 21 can be prevented.

FIG. 1

10 (SOLDER COMPOSITION)
(MEDIUM) 13   (ORGANIC FILM) 11   (SOLDER PARTICLE) 12
21 (ELECTRODE)   20 (SUBSTRATE)

EP 1 795 293 A1

**Description**

TECHNICAL FIELD

The present invention relates to a mounting technique for semiconductor devices and electronic components, and in particular, to a solder composition for forming a solder layer on an electrode provided on a substrate, and a solder layer forming method using the same.

BACKDGOUND ART

Conventionally, to form a solder layer on a substrate, there have been known: a printing method in which solder paste is printed on a substrate through a metal mask pattern, and then heat-melted so as to form a solder layer; a dip method in which a substrate is dipped in melted solder so as to be precoated with the solder; a vapor deposition method in which a pattern is formed on a substrate by a photolithographic method, and then a solder layer is formed by vacuum vapor deposition; and a plating method in which a solder layer is formed by electroplating. Note that the substrate collectively refers to a substrate on which electric components are to be mounted or on which electric components have been mounted such as a semiconductor substrate, a printed wiring board, and an interposer substrate.

Further, Patent Document 1 describes art to form a solder layer on an electrode on a substrate by heating a mixture of solder powder and organic metal salt to thereby deposit a desired solder alloy by substitution reaction between the solder and the organic metal salt.

Moreover, although it is not a solder layer forming method, Patent Document 2 describes an in-oil atomization method in which solder is melted in a heated disperse medium of oily liquid, and by stirring it, fine particles of droplets are formed, which are cooled and solidified to thereby form spherical solder particles.

Patent Document 1: Japanese Patent Publication No. 2975114
Patent Document 2: Japanese Patent Laid-Open Publication No. 2003-166007

DISCLOSURE OF THE INVENTION

PROBLEMS TO BE SOLVED BY THE INVENTION

However, in the conventional solder layer forming method described above, there have been following problems relating to recent technical trends such as miniaturization and narrower pitch of electrodes and lead-free solder.

Printing method is the most typical technique for mounting electronic components on a printed wiring board. However, relating to formation of a solder layer on a minute narrow-pitch electrode, the method involves various problems such as difficulty in processing a metal mask, lowering of the mechanical strength thereof, and further, dripping of solder paste after printing, and occurrence of short-circuit failure (bridge) corresponding thereto.

Dip method involves such problems that bridge is caused in a narrow-pitch electrode, solder erosion is caused in a minute electrode, and further a thick solder layer cannot be formed because of the surface tension of the solder.

Vacuum vapor deposition method requires very high production cost since it involves photolithography process, so it is limited to special-purpose items.

Plating method is effective for conventional tin-lead solder. However, plating of a lead-free solder such as a tin-silver-copper solder is extremely difficult since deposition potential of composite metal becomes significantly high. Further, kinds of metal to which electroplating is possible are limited. Moreover, a seed layer (metal conducting layer) formed on a processed part for applying electric-field must be removed by etching after plating. Therefore, occurrence of a short-circuit failure (insulation failure) between electrodes due to poor etching is increasingly acknowledged as a problem along with development of fine pitch.

Further, in the art described in Patent Document 1, tin having large ionization trend of the tin-lead alloy powder becomes tin ion, causing substitution reaction with lead of organic lead salt so that lead is absorbed by the tin-lead alloy powder, whereby the melting point falls corresponding to an increase in the lead composition, so the tin-lead alloy powder melts and is deposited on the electrode. However, since the ionization trend in alloy series governs the substitution reaction here same as the case of electroplating, the range of selecting the alloy series is not so wide. Further, since the melting point of a solder alloy of tin-silver-copper series is not sensitive to composition variation, it is very difficult to from an alloy of constant composition on a minute electrode uniformly. Namely, since it is a material involving a problem of easily causing composition variation, it is difficult to form a solder layer of uniform composition.

It is an object of the present invention to provide a solder composition capable of solving the various problems described above associating with miniaturization of an electrode and lead-free solder, and a solder layer forming method using the same.

MEANS FOR SOLVING THE PROBLEMS

In order to achieve the object, a solder composition according to the present invention is a solder composition used for forming a solder layer on an electrode on a substrate, including a mixture of solder powder and a medium, characterized in that the solder powder includes coalescence inhibition films which inhibit coalescence of particles of the solder powder, and the medium is a solvent in which the boiling point thereof is not lower than the soldering temperature. Further, the coalescence inhibition coating desirably consists of an organic film. Note that the medium may be in a liquid or paste form.

Particles of the solder powder (hereinafter referred to as solder particles) are in an almost spherical shape and almost uniform in diameter. Now, when the solder composition is heated to the soldering temperature (including the melting point of the solder powder) or higher, the n number of solder particles coalesce, and the volume and amount of organic film of the coalesced solder particles become n times, and the surface area thereof becomes $n^{2/3}$ times. Therefore, in a new solder particle formed of n pieces of coalesced solder particles, the amount of the organic film per unit surface area becomes $n^{1/3}$ times. In other words, as coalescence of solder particles proceeds, the amount of organic film per unit surface area of the coalesced solder particles increases. For instance, if eight solder particles coalesce, the volume and amount of the organic film of the coalesced solder particles become eight times, the surface area thereof becomes four times, and the amount of organic film per unit surface area becomes two times. Further, as the amount of organic film per surface area increases, contact between solder particles covered with organic films becomes difficult, so coalescence of solder particles is inhibited.

On the other hand, a solder layer on an electrode grows by coalescence of solder particles with the solder layer. Therefore, as coalescence of solder particles on the electrode proceeds, when the amount of organic film per unit surface area of the solder layer reaches a certain level, the growth of the solder layer stops. Namely, the final solder amount of the solder layer is determined depending on the size of the electrode as well as the initial size of solder particles and amount of organic films. Note that a solder particle in which the amount of the organic film per unit surface area reaches a certain level will not coalesce with the solder layer either.

Thereby, it is possible to inhibit coalescence of solder particles on the electrode beyond necessity, so the solder amount of the solder layer can be uniform, and a short -circuit failure of the electrode can be prevented. For example, the initial amount of the organic films of the solder particles is set such that coalescence of solder particles with the solder layer is allowed until the solder layer becomes to have a certain solder amount and is inhibited, when the amount exceeds the certain solder amount.

In the solder composition according to the present invention, at least one of a coalescence accelerator which accelerates coalescence of particles of the solder powder or a coalescence inhibitor which inhibits coalescence of particles of the solder powder may be added to the mixture. The coalescence accelerator desirably includes an acid component which desirably includes at least one of carboxylic acid and rosin. Further, the coalescence inhibitor desirably includes organic acid metal salt which is desirably made of the acid component and metal constituting the particle of the solder powder. Since the coalescence accelerator includes an acid component and the coalescence inhibitor includes organic acid metal salt, an acid component or organic acid metal salt may be included as the main component. Moreover, an acid component/organic acid metal salt may be included in a new coalescence accelerator/coalescence inhibitor.

Since an acid component accelerates coalescence of solder particles and organic acid metal salt inhibits coalescence of solder particles, action of organic films can be regulated. Carboxylic acid as an acid component may be formic acid, oleic acid, stearic acid, oxalic acid or the like. Rosin as an acid component may be L-abietic acid, rosin, a rosin derivative such as hydrogenerated rosin or the like.

Further, a particle of the solder powder is desirably any one of tin, indium and an alloy thereof. Further, a particle of the solder powder may be an alloy in which at least one of copper, silver, gold, nickel, lead, bismuth, antimony, zinc, germanium, and aluminum is included in the simple metal or the alloy. Further, the medium may include at least one of carbon hydrides, esters, alcohols and glycols.

A solder layer forming method according to the present invention is characterized as to include the steps of: applying a mixture of solder powder and a medium on a substrate; and melting the solder powder and controlling coalescence of particles of the solder powder to thereby form a solder layer by the solder powder on an electrode on the substrate.

Next, a method of designing solder particles and the amount of organic films thereof, in order to achieve a desired height of the solder layer, will be described.

It is assumed that the volume of a solder particle is V1 and the amount of the organic film is F1. The solder particle is in a spherical shape. It is assumed that the overall volume of the solder particles coalesced for forming a solder layer is V2, the amount of the organic film is F2, and the surface area is S2. The area of an electrode is assumed to be S0. The correction coefficient indicating the relationship between the surface area of the solder layer and the area of the electrode is assumed to be A. The maximum amount of the organic film per unit surface area of the whole solder particles coalesced for forming the solder layer is assumed to be Fmax.

In this case, the following relationships are established.

$$F2=(V2/V1)*F1 \quad \cdots \quad (1)$$

$$Fmax=F2/S2 \quad \cdots \quad (2)$$

$$S2=A*S0 \quad \cdots \quad (3)$$

By assigning the equation (3) to the equation (2), the following equation is obtained.

$$Fmax=F2/(A*S0)$$

$$\therefore F2=Fmax*A*S0 \quad \cdots \quad (4)$$

Next, by assigning the equation (4) to the equation (1), the following equations are obtained.

$$Fmax*A*S0=(V2/V1)*F1 \quad \cdots \quad (5)$$

$$\therefore F1=(V1/V2)*Fmax*A*S0 \quad \cdots \quad (6)$$

Here, V2 is determined corresponding to the desired height of the solder layer, and if V1, Fmax, A and S0 have been determined, F1 is calculated from the equation (6).

Further, if the size of the solder particle (that is, V1) has not been determined, F1 and V1 satisfying the relationship of the following equation obtained from the equation (5) are obtained.

$$F1/V1=(1/V2)*Fmax*A*S0 \quad \cdots \quad (7)$$

Note that in the equation (3), the correction coefficient A results in different values depending on the volume of the solder layer, the shape of the electrode, the surface tension of the overall solder particles coalesced for forming the solder layer, and the like. For example, larger the volume of the solder layer is, larger the surface area of the solder layer is, so A also takes a larger value. The surface area becomes larger if the shape of the electrode is square rather than round, since it is not subject to be a spherical surface, so A also takes a larger value. The surface area becomes larger if the surface tension of the overall solder particles coalesced for forming the solder layer is lower, since it is not subject to be a spherical surface, so A also takes a larger value. An actual correction coefficient A is calculated experimentally.

As described above, the present invention has been developed by focusing attention on a phenomenon in which coalescence of solder particles in solder paste proceeds to form a solder connection in a conventional method of mounting electronic components using solder paste. In the present invention, a solder layer of the desired solder amount can be formed on an electrode by controlling coalescence of solder particles.

In solder paste, an activator is added since the surface of solder powder is oxidized. In order to cope with a fine pattern, a solder particle must be fine as well. Along with it, as the total surface area of the particles of the solder powder increases, the activator in the solder paste required for oxidizing the surface tends to increase. Further, the oxidized film on the surface of the solder particle has an effect of preventing aggregation of solder particles, so it is an important element in fabricating the solder paste. However, from the viewpoint of miniaturization and solderability, an increase in the oxidized amount of the solder powder is not preferable. Therefore, in the present invention, by focusing attention on an organic film as a means for preventing aggregation, coalescence of solder particles is controlled by forming organic films on the surfaces of solder particles.

Namely, the present invention is a solder composition consisting of solder powder having organic films on the surfaces, and a solvent (medium) for dispersing the solder powder. For example, by granulating solder by means of the in-oil atomization method described in Patent Document 2, an organic film can be formed on the surface of a solder particle. Further, the boiling point of the solvent (medium) is not lower than the soldering temperature including the melting point of the solder. Moreover, an acid component or organic acid metal salt for regulating the action of the organic film may be applied.

Then, when the solder composition is applied to an electrode on a substrate and heated to the soldering or higher, the solder powder fuses. At this time, since particles of the solder powder contacting the electrode are made wet on the electrode, a solder layer is formed. In the solder layer on the electrode, the organic film on the surface becomes dense each time coalescence with particles of the solder powder is repeated. Then, when the organic film exceeds a certain amount, it acts to prevent coalescence with particles of the solder powder. Due to this action, a solder layer of the required solder amount is formed but excess coalescence with solder particles is prevented, whereby a short-circuit failure is prevented. Note that the added acid component functions as an accelerator for coalescence, and the added organic acid metal salt functions as an inhibitor for coalescence, both of which regulate the action of the organic film.

EFFECTS OF THE INVENTION

As described above, according to the present invention, a solder composition consisting of a medium having the boiling point not lower than the soldering temperature and solder powder having organic films is applied to an electrode part on a substrate and is heated to the soldering temperature or higher to thereby form a solder layer on the electrode on the substrate, and further, excess coalescence of solder particles can be prevented by the growth of the organic film on the surface of the solder layer. Therefore, it is possible to easily form a solder layer at low cost in which a short-circuit failure will not be caused even in a fine electrode pattern with excellent composition uniformity.

In other words, in a technique to form a solder layer on an electrode part on a substrate, it is possible to form a solder layer having a sufficient solder amount in which mask position accuracy is not needed in the printing method or the like, a short-circuit failure is prevented, and the composition is uniform, with respect to the recent miniaturization of electrode and lead-free solder. That is, it is possible to provide a solder composition excellent in cost performance and a solder layer forming method using the same.

BEST MODE FOR CARRING OUT THE INVENTION

Hereinafter, an embodiment of the present invention will be described in detail based on the drawings.

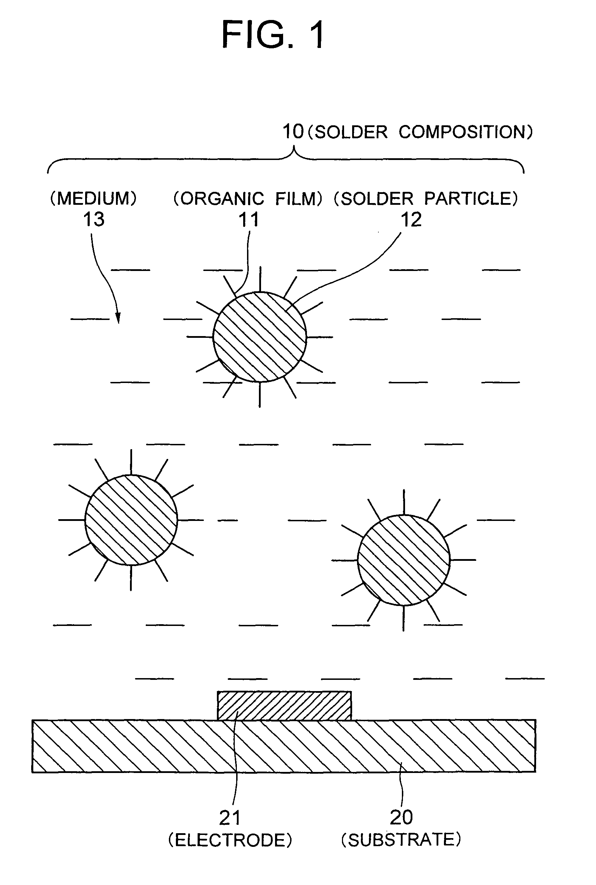

Fig. 1 is a schematic sectional view showing a solder composition according to an embodiment of the present invention.

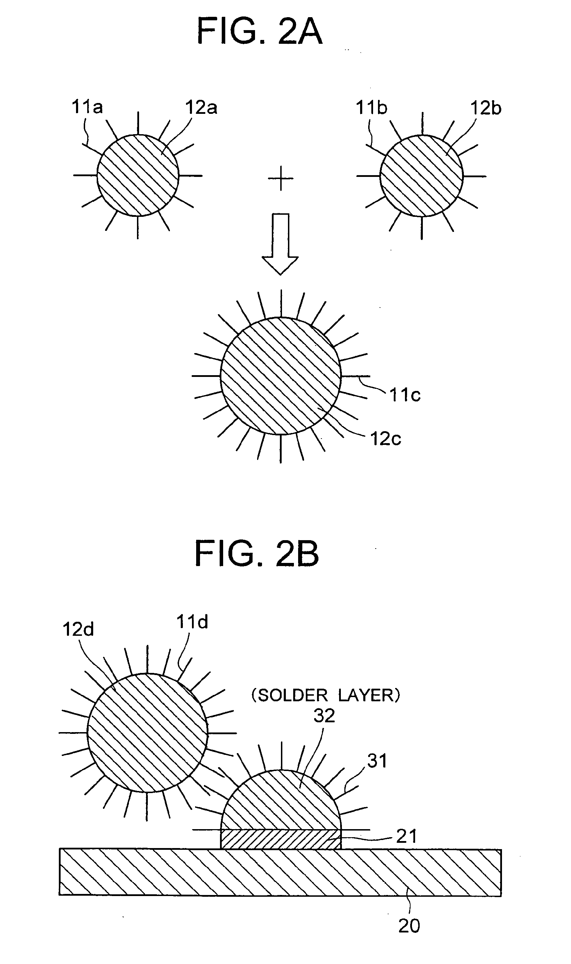

As shown in Fig. 1, a solder composition 10 is applied to an electrode 21 formed on a substrate 20. The solder composition 10 is for forming a solder layer 32 (Fig. 2B) on the electrode 21, including solder powder having organic films 11 and a medium 13 having a boiling point not lower than the melting point of the solder powder. The solder powder is manufactured by an in-oil atomization method for example. The medium 13 has a boiling point not lower than the melting point of the solder powder, that is, a boiling point not lower than the soldering temperature for example, and it may be in a liquid or paste form. As shown in Fig. 1, each particle of the solder powder (solder particle 12) is covered with the organic film 11 on the surface thereof.

Figs. 2A, 2B are schematic sectional views showing actions of the solder composition of Fig. 1. Hereinafter, explanation will be given based on this drawing.

Figs. 2A, 2B show a state where the solder composition 10 (Fig. 1) is heated to the melting point of the solder powder or higher, in which Fig. 2A shows a state of coalescence of solder powder particles (solder particles) 12a and 12b, and Fig. 2B shows a state of coalescence of the solder particle 12d with the solder layer 32. However, the medium 13 (Fig. 1) is not shown.

As shown in Fig. 2A, the solder particles 12and 12b are almost in a spherical shape, and the diameters are uniform and the amounts of the organic films 11a and 11b are same. Now, it is assumed that the two solder particles 12a and 12b coalesce to thereby form a new solder particle. 12c. In the solder particle 12c, the volume is doubled and the amount of the organic film 11c is also doubled, compared with the solder particle 12a or 12b, but the surface area is only 1.59 times as large as the solder particle 12a or 12b. Therefore, in the solder particle 12c formed of the coalesced solder particles 12a and 12b, the amount of organic film 11c per unit surface area becomes about 1.26 times. Namely, as coalescence of the solder particle 12c proceeds, the amount of the organic film 11c per unit surface area increases. Further, as the amount of the organic film 11a and 11b per unit surface area increases, contact between the solder particles 12a and 12c under the organic films 11a and 11b becomes difficult, so coalescence of the solder particles 12a and 12b is inhibited.

On the other hand, the solder layer 32 on the electrode 21 is in a hemispherical shape, and grows as the solder particle 12d coalesces with the solder layer 32, as shown in Fig. 2B. Therefore, as coalescence of the solder particle 12d proceeds, when the amount of the organic film 31 per unit surface area of the solder layer 32 reaches a certain level, growth of the solder layer 32 stops. In other words, the final solder amount of the solder layer 32 is determined depending on the area of the electrode 21 and the initial size of the solder particles 12a and 12b and amount of the organic layers 11a and 11b. Further, if the amount of the organic film 11d per unit surface area reaches a certain level, the solder particle 12d will not coalesce with the solder layer 32. In other words, if either the amount of the organic film 31 per unit surface area of the solder layer 32 or the amount of the organic film 11d per unit surface area of the solder particle 12d reaches a certain value, coalescence will not be completed.

This enables to inhibit coalescence of the solder particle 12d on the electrode 21 beyond necessity, so a short-circuit failure of the electrode 21 can be prevented. For example, the initial amount of the organic films 11a and 11b of the solder particles 12a and 12b is set such that coalescence of the solder particle 12d with the solder layer 32 is allowed until the solder layer 32 becomes a certain solder amount but is inhibited when it exceeds a certain solder amount.

Example 1

First, 90g of Sn-Ag-Cu solder and 18g of maleic acid modified rosin were added to 900g of purified caster oil in a container. The tin-silver-copper solder was a lead-free solder having the composition of Sn-3.0mass%Ag-0.5mass%Cu and the melting point of 220°C. Then, by heating the purified caster oil to 230°C and rotating the stirrer at 10,000rpm, the solder alloy was crushed in the purified caster oil. Thereby, solder powder in which the surface of a solder particle was coated with an organic film of maleic acid modified rosin was acquired. Note that during stirring, the inside of the container was substituted by nitrogen atmosphere. Further, the solder powder was cleaned with ethyl acetate after the supernatant liquid of the container was removed, and then vacuum-dried.

Next, 1.5g of the obtained solder powder was dispersed in 50ml of polyol ester (trimethylolpropane fatty acid condensation ester) to thereby prepare the solder component. Then, the solder composition was applied to a silicon chip which was pattern formed with an electrode diameter 0 of 40μm and an electrode pitch of 80μm, and was heat-melted under the condition of peak temperature 260°C. The electrode was made of Ni/Au plating. Thereby, after forming a solder layer, ultrasonic cleaning was performed the silicon chip in ethyl acetate, and after drying, outer appearance testing and measurement of the height of the solder layer were performed by using a laser microscope.

As a result, short-circuit failure was zero among 14639 pieces of electrodes on a silicon chip of 10 mm X 10 mm, and formation of a solder layer having an average height of about 20pm (about σ=2) was confirmed.

Example 2

1.5g of solder powder having organic films on the surfaces, obtained through the same method as that of the example 1, was dispersed in 50ml of polyol ester in which 0.165g of stearic acid and 0.35g of tin stearate acid were added, to thereby prepare a solder composition.

The solder composition was applied to a resin substrate on which protruded electrodes of 50μm height (electrode diameter 100μm) were formed in 200μm pitches, and heat-melted under the condition of the peak temperature being 260°C to thereby form a solder layer. After forming the solder layer, ultrasonic cleaning was performed to the resin substrate in ethyl acetate, and after drying, outer appearance testing and measurement of the height of the solder layer were performed by using a laser microscope. As a result, short-circuit failure was zero among 1600 pieces of electrodes on the substrate, and formation of a solder layer having the average height (including height of protruded electrode) of about 70μm (about σ=3.4) was confirmed.

Example 3

2.0g of solder powder having organic films on the surfaces thereof, obtained through the same method as that of the example 1, was dispersed in 50ml of polyalkylene glycol in which 1ml of oleic acid was dispersed, to thereby prepare a solder composition.

The solder composition was applied to a silicon chip which was pattern-formed with an electrode diameter 0 of 40μm and an electrode pitch of 80μm, and was heat-melted under the condition of the peak temperature being 260°C.

Thereby, after a solder layer was formed through this process, ultrasonic cleaning was performed to the silicon chip in ethyl acetate, and after drying, outer appearance testing and measurement of the height of the solder layer were performed by using a laser microscope.

As a result, short-circuit failure was zero among 14639 pieces of electrodes on a silicon chip of 10 mm X 10 mm, and formation of a solder layer having the average height of about 25pm (about $\sigma=2$) was confirmed.

INDUSTRIAL APPLICABILITY

As described above, the present invention is able to provide a solder composition capable of solving various problems caused by fine electrodes and lead-free solders, and a solder layer forming method using the same.

BRIEF DESCRIPTION OF THE DRAWINGS

Fig. 1 is a schematic sectional view showing an embodiment of the solder composition according to the present invention.
Figs. 2A, 2B are schematic sectional views showing actions of the solder composition in Fig. 1.

DESCRIPTION OF REFERENCE NUMERALS

| | |
|---|---|
| 10 | solder composition |
| 11, 11a, 11b, 11c, 11d | organic film of solder particle |
| 12, 12a, 12b, 12c, 12d | solder particle |
| 13 | medium |
| 20 | substrate |
| 21 | electrode |
| 31 | organic film of solder layer |
| 32 | solder layer |

**Claims**

1. A solder composition used for forming a solder layer on an electrode on a substrate, comprising,
a mixture of solder powder and a medium, wherein
the solder powder includes coalescence inhibition films which inhibit coalescence of particles of the solder powder, and
the medium is a solvent in which a boiling point thereof is not lower than a soldering temperature.

2. The solder composition as claimed in claim 1, wherein the coalescence inhibition coating is made of an organic film.

3. The solder composition as claimed in claim 1, wherein at least one of a coalescence accelerator which accelerates coalescence of the particles of the solder powder and a coalescence inhibitor which inhibits coalescence of the particles of the solder powder is added to the mixture.

4. The solder composition, as claimed in claim 3, wherein the coalescence accelerator includes an acid component.

5. The solder composition, as claimed in claim 4, wherein the acid component includes at least one of carboxylic acid and rosin.

6. The solder composition, as claimed in claim 3, wherein the coalescence inhibitor includes organic acid metal salt.

7. The solder composition, as claimed in claim 6, wherein the organic acid metal salt is made of the acid component and metal constituting the particle of the solder powder.

8. The solder composition, as claimed in claim 1, wherein the particle of the solder powder is any one of tin, indium and an alloy thereof.

9. The solder composition, as claimed in claim 1, wherein the particle of the solder powder is an alloy in which at least one of copper, silver, gold, nickel, lead, bismuth, antimony, zinc, germanium, and aluminum is included in the simple metal or the alloy.

10. The solder composition, as claimed in claim 1, wherein the medium includes at least one of carbon hydrides, esters, alcohols and glycols.

11. A solder layer forming method, comprising the steps of:

applying a mixture of solder powder and a medium on a substrate; and
melting the solder powder and controlling coalescence of particles of the solder powder to thereby form a solder layer by the solder powder on an electrode on the substrate.

# FIG. 1

10 (SOLDER COMPOSITION)

(MEDIUM)    (ORGANIC FILM) (SOLDER PARTICLE)
13              11              12

21
(ELECTRODE)

20
(SUBSTRATE)

# FIG. 2A

11a     12a           11b     12b

+

11c

12c

# FIG. 2B

12d     11d

(SOLDER LAYER)

32

31

21

20

<table>
<tr><td colspan="2">**INTERNATIONAL SEARCH REPORT**</td><td>International application No.<br>PCT/JP2005/014508</td></tr>
</table>

| A. | CLASSIFICATION OF SUBJECT MATTER |
|---|---|

Int.Cl$^7$  B23K35/22, 35/26

According to International Patent Classification (IPC) or to both national classification and IPC

| B. | FIELDS SEARCHED |
|---|---|

Minimum documentation searched (classification system followed by classification symbols)
Int.Cl$^7$  B23K35/00-35/40

Documentation searched other than minimum documentation to the extent that such documents are included in the fields searched

| Jitsuyo Shinan Koho | 1922-1996 | Jitsuyo Shinan Toroku Koho | 1996-2005 |
| Kokai Jitsuyo Shinan Koho | 1971-2005 | Toroku Jitsuyo Shinan Koho | 1994-2005 |

Electronic data base consulted during the international search (name of data base and, where practicable, search terms used)

| C. | DOCUMENTS CONSIDERED TO BE RELEVANT |
|---|---|

| Category* | Citation of document, with indication, where appropriate, of the relevant passages | Relevant to claim No. |
|---|---|---|
| Y | WO 2004/026526 A1  (EBARA CORP.),<br>01 April, 2004 (01.04.04),<br>Claims; pages 32 to 35; Fig. 1<br>& JP 2004-107728 A | 1-11 |
| Y | EP 1245315 A1  (TAMURA KAKEN CORP.),<br>02 October, 2002 (02.10.02),<br>Claims; Par. Nos. [0036], [0043]<br>& JP 2003-166007 A | 1-3,6,7 |
| Y | JP 5-337680 A  (Alps Electric Co., Ltd.),<br>21 December, 1993 (21.12.93),<br>Claims; Par. No. [0010]<br>(Family: none) | 1-11 |

| ☒ | Further documents are listed in the continuation of Box C. | ☐ | See patent family annex. |
|---|---|---|---|

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search<br>08 September, 2005 (08.09.05) | Date of mailing of the international search report<br>20 September, 2005 (20.09.05) |
|---|---|
| Name and mailing address of the ISA/<br>Japanese Patent Office | Authorized officer |
| Facsimile No. | Telephone No. |

Form PCT/ISA/210 (second sheet) (January 2004)

**INTERNATIONAL SEARCH REPORT**

| International application No. |
| --- |
| PCT/JP2005/014508 |

C (Continuation).    DOCUMENTS CONSIDERED TO BE RELEVANT

| Category* | Citation of document, with indication, where appropriate, of the relevant passages | Relevant to claim No. |
| --- | --- | --- |
| Y | JP 2001-232496 A  (Taiho Kogyo Co., Ltd.), 28 August, 2001 (28.08.01), Claims; Par. Nos. [0017], [0020], [0026], [0032]; tables 2, 3 (Family: none) | 1-11 |
| Y | JP 11-254184 A  (Harima Chemicals, Inc.), 21 September, 1999 (21.09.99), Claims; Par. No. [0013]; table 2 (Family: none) | 3,6,7 |
| A | JP 5-192786 A  (Seiko Instruments Inc.), 03 August, 1993 (03.08.93), Claims (Family: none) | 1,3-5 |
| A | JP 3-013293 A  (Yuho Kemikaru Kabushiki Kaisha), 22 January, 1991 (22.01.91), Claims; page 2, upper right column (Family: none) | 1,3-5 |

Form PCT/ISA/210 (continuation of second sheet) (January 2004)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2975114 B

- JP 2003166007 A